Europäisches Patentamt

European Patent Office

Office européen des brevets

(19)

(11) Publication number: **0 214 296 B1**

## EUROPEAN PATENT SPECIFICATION

(12)

(45) Date of publication of patent specification: **17.06.92**

(51) Int. Cl.⁵: **H05K 7/02**, H05K 7/14, H05K 7/20

(21) Application number: **86901481.1**

(22) Date of filing: **12.02.86**

(86) International application number:
**PCT/JP86/00057**

(87) International publication number:
**WO 86/05061 (28.08.86 86/19)**

(54) **STRUCTURE FOR MOUNTING ELECTRONIC DEVICES.**

(30) Priority: **13.02.85 JP 25611/85**
**13.02.85 JP 25612/85**

(43) Date of publication of application:
**18.03.87 Bulletin 87/12**

(45) Publication of the grant of the patent:
**17.06.92 Bulletin 92/25**

(84) Designated Contracting States:
**CH DE FR GB IT LI NL SE**

(56) References cited:
**FR-A- 2 358 807**
**JP-A-60 200 596**

(73) Proprietor: **FUJITSU LIMITED**
**1015, Kamikodanaka Nakahara-ku**
**Kawasaki-shi Kanagawa 211(JP)**

(72) Inventor: **ONO Izumi**
**19-3, Motoyokoyamacho 1-chome Hachioji-shi**
**Tokyo 192(JP)**
Inventor: **TAKAYAMA, Haruo**
**29-3-104, Kamitsuruma 4-chome**
**Sagamihara-shi Kanagawa 228(JP)**
Inventor: **TAKAHASHI, Yasuo**
**B-1117, 1-1, Ogura, Saiwai-ku**
**Kawasaki-shi Kanagawa 211(JP)**
Inventor: **OKUMURA, Eichiro**
**Fujitsushimonogeryo, 878 Shimonoge,**
**Takatsu-ku**
**Kawasaki-shi Kanagawa 213(JP)**

(74) Representative: **Sunderland, James Harry et al**
**HASELTINE LAKE & CO Hazlitt House 28**
**Southampton Buildings Chancery Lane**
**London WC2A 1AT(GB)**

Rank Xerox (UK) Business Services

## Description

The present invention relates to a mounting structure for electronic apparatus, the mounting structure including a power supply structure between a power supply and the electronic apparatus, such as a printed wiring board, and a cooling structure to be used for the electronic apparatus, to provide, for example, a computer system. In particular, the power supply structure may be such that the power is supplied through a bath plate having a plurality of conductive layers and the mounting structure such that it is suitable for air cooling by a fan.

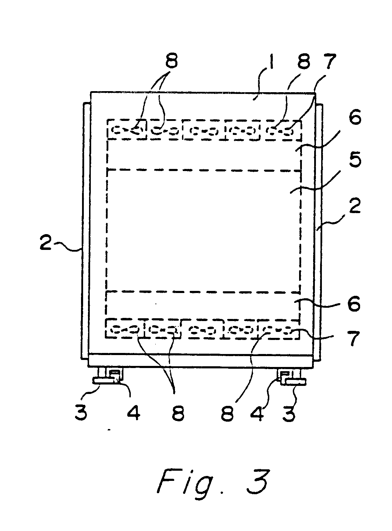

An electronic apparatus such as an electronic computer system is structured as shown in the side elevation of Fig. 3.

An electronic apparatus 5 is housed in an enclosure 1 which is provided with a door 2 to be opened or closed. Moreover, the housed electronic apparatus 5 is provided with a fan unit 7 and a duct 6 and the electronic apparatus 5 is cooled by air by driving fans 8.

At the bottom part of enclosure 1, legs 3 for supporting the enclosure 1 from a floor surface and casters 4 for transferring the enclosure 1 along the floor surface are further provided.

A recent electronic apparatus 5 is formed of semiconductor elements such as LSIs, which assure high packing density and high-speed operation, a one-board substrate on which an electronic circuit is formed by mounting circuit elements on a single multilayered print wiring board, and a power supply which supplies specified power to said one-board substrate.

In the case of such electronic apparatus, the power source supplied to the one-board substrate from the power supply suffers less voltage drop if provided through buses which are as short as possible. It is also desired that cooling efficiency should be high, because the one-board substrate generates a large amount of heat.

Accordingly, it is generally important for such electronic apparatus that the structure thereof can be formed compactly, and without problems for an air cooling system.

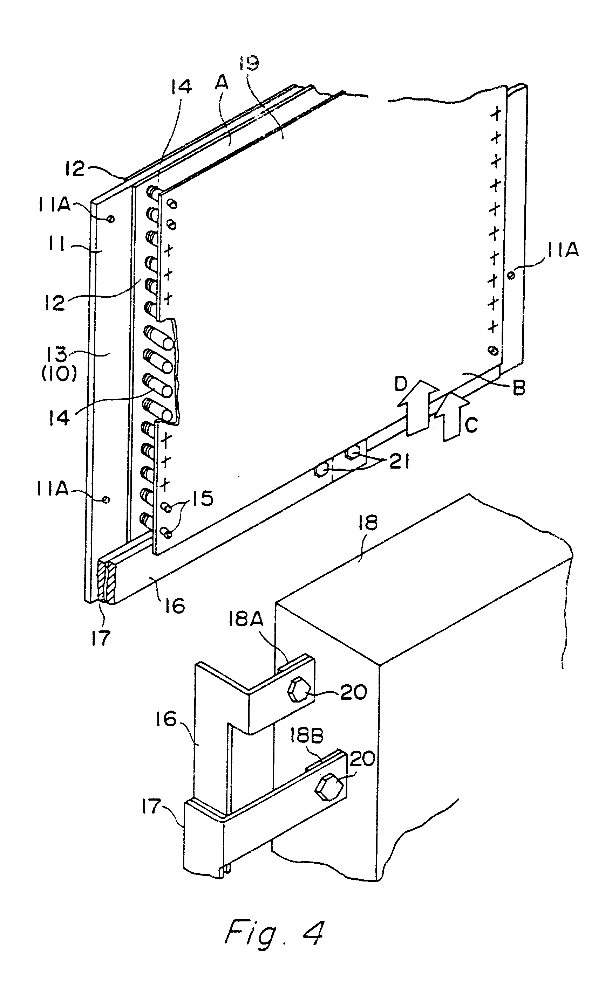

The structure of an electronic apparatus of the prior art is indicated in the perspective view of Fig. 4.

A unit 10 formed by a one-board substrate 19, engaged with one or both surfaces of a bus plate 13 through posts 14, and a power supply unit 18 provided with output terminals 18A, 18B are arranged together. The bus plate 13 is composed of a conductive layer 11, which is provided with mounting holes 11A for mounting to an enclosure frame and is connected to earth, and conductive layers 12 which are layered in both sides of conductive layer 11, in order to hold it via insulating materials, and are connected to the specified power source voltage.

Moreover, posts 14 fixed respectively either to the conductive layer 11 or conductive layer 12 of bus plate 13 are conductively connected to predetermined lands of the one-board substrate 19 via screws 15 screwed to threaded holes provided at the end portions of the posts through fitting holes of the one-board substrate 19.

A post 14 is formed by a flexible conductive material and it should desirably be extensive and compressive (for detail, refer to the Japanese Patent Application No. 59-111280).

Power supply bars 16, 17 extend between the bus plate 13 and power supply unit 18, the conductive layer 11 is connected to the power supply bar 16 whilst the conductive layer 12 is connected to the power supply bar 17 respectively, by screwing bolts 21 to the bus plate 13. Moreover, the power supply bar 16 is connected to output terminal 18A whilst the power supply bar 17 is connected to the output terminal 18B respectively by screwing bolts 20, and the power sources from the output terminals 18A, 18B of power supply unit 18 are supplied to the one-board substrate 19 through the bus plate 13 and posts 14.

Cooling can be effected in such a way that a surface B of one-board substrate 19 is cooled by ventilation in the direction of an arrow mark D in Fig. 4, whilst a space A is cooled by ventilation in the direction of arrow mark C in Fig. 4.

Such a structure, however, suffers a problem in that power supply buses become long, and thereby voltage drops occur because the power source of power supply unit 18 is supplied through the extended power supply bars 16 and 17.

In addition, in case the unit 10 and power supply unit 18 forming prescribed ventilation paths are arranged only to upper and lower sides or to right and left sides or to the front and to the back, respective ventilation resistances are different, ventilation within the enclosure 1 (Fig. 3) is unbalanced when cooling takes place, and thereby the cooling efficiency is deteriorated. On the other hand, a problem arises in that a dead space is generated in the co-arrangement of units and external appearance becomes large in size.

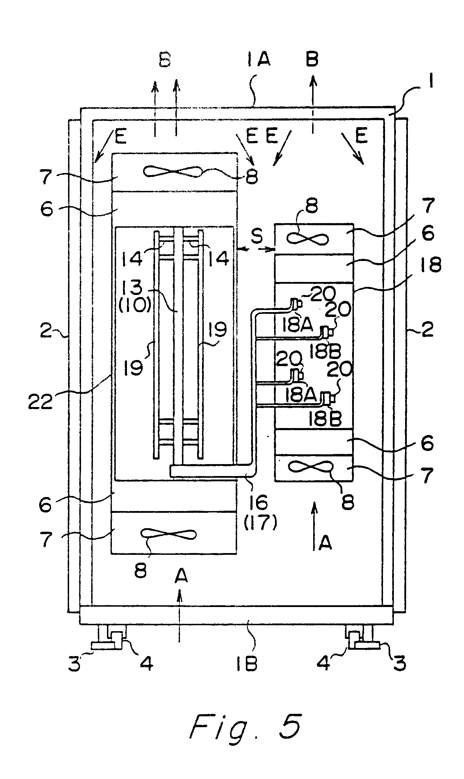

Fig. 5 is a detailed side elevation of the structure shown in Fig. 3. The unit 10 which is formed by one-board substrates 19 engaged to both sides of bus plate 13 through posts 14 and an air cover 22 which covers the one-board substrates 19, and the power supply unit 18 provided with the output terminals 18A, 18B are arranged together within the enclosure 1. Moreover, ducts 6 and fan units 7 are provided at upper and lower end portions of the unit 10 and power supply unit 18.

Driving a fan 8 takes external air in the direction of an arrow mark A in the Figure from the bottom part 1B of the enclosure 1 and exhausts the air in the direction of an arrow mark B from the ceiling part 1A, to cool the unit 10 and power supply unit 18.

In such a structure, since power source of the power supply unit 13 is supplied by extended power supply bars 16 and 17, the power supply path becomes longer, resulting in voltage drop. Moreover, a dead space of extent S is generated between the unit 10 and power supply unit 18 and the external appearance of the enclosure 1 becomes large in size.

Moreover, the structure shown in Fig. 5 has also suffered a problem in relation to air cooling in that since the unit 10 with the one-board substrates 19 and the power supply unit have different ventilation resistances, a part of the air to be exhausted is taken in the direction of an arrow mark E at the time of exhaustion from the ceiling part 1B as shown in Fig. 5, and high-temperature air which should be exhausted thus remains within the enclosure 1, lowering the cooling efficiency.

The existing structure suffers a problem also from the point of view of cost and mounting efficiency in that a separating plate must be provided between the power supply 18 and the unit 10, or a duct which directly opens at least one exhaust aperture to the exterior of the enclosure must be provided in order to adjust migration of exhaust air and balance in amounts of air.

FR-A-2 358 807 discloses a circuitry module with circuit boards carrying electronic components mounted on a chassis. The chassis provides supply buses for the circuit boards and fans are provided for cooling.

According to the present invention there is provided an electronic apparatus mounting structure comprising a bus plate which is formed by stacking a plurality of conductive layers through insulating layers; the conductive layers corresponding to a plurality of power supply voltages; the bus plate being provided with a plurality of posts electrically connected to both the conductive layers and a plurality of connecting pieces extrudingly formed at different positions from each conductive layer at the one surface thereof,

a power supply which comprises the power supply circuit which supplies said plurality of power supply voltages and provides a plurality of output terminals formed at positions respectively corresponding to the positions of the plurality of connecting pieces of said bus plate,

a printed wiring board having electronic parts mounted thereon and having power supply lands at positions corresponding to the positions of the plurality of posts of said bus plate,

the printed wiring board being stacked on one surface of the bus plate and being secured to the bus plate, the lands of said printed wiring board being electrically connected to the corresponding posts at the one surface of said bus plate, said power supply being located at the other surface of said bus plate and being secured to the bus plate, each connecting piece of the bus plate being electrically connected to each corresponding output terminal of the power supply.

In the case of the present invention, arranged power supply output terminals are provided on a predetermined surface of a power supply unit, connecting pieces matching said predetermined output terminals are formed respectively in relation to conductive layers of a bus plate, said power supply output terminals and said connecting pieces are pressurised and connected and said bus plate is connected to a one-board substrate through posts.

Such mounting structure is capable of preventing power supply voltage drops and unbalances, and of realising a very compact structure as a whole.

Reference is made, by way of example, to the accompanying drawings, in which:-
Fig. 1 is a perspective view of a disassembled structure of an embodiment of the present invention,
Fig. 2 is a detailed plan view (a), a front elevation (b) and a side elevation (c) of structure of said embodiment,
Fig. 3 is a side elevation of an ordinary electronic apparatus,
Fig. 4 is a perspective view of the principal portions illustrating a prior art structure,
Fig. 5 is a detailed side elevation of Fig. 3, and
Fig. 6 is a plan view (a), a front elevation (b) and a side elevation (c) of a mounting structure utilising the embodiment of the present invention shown in Fig. 2.

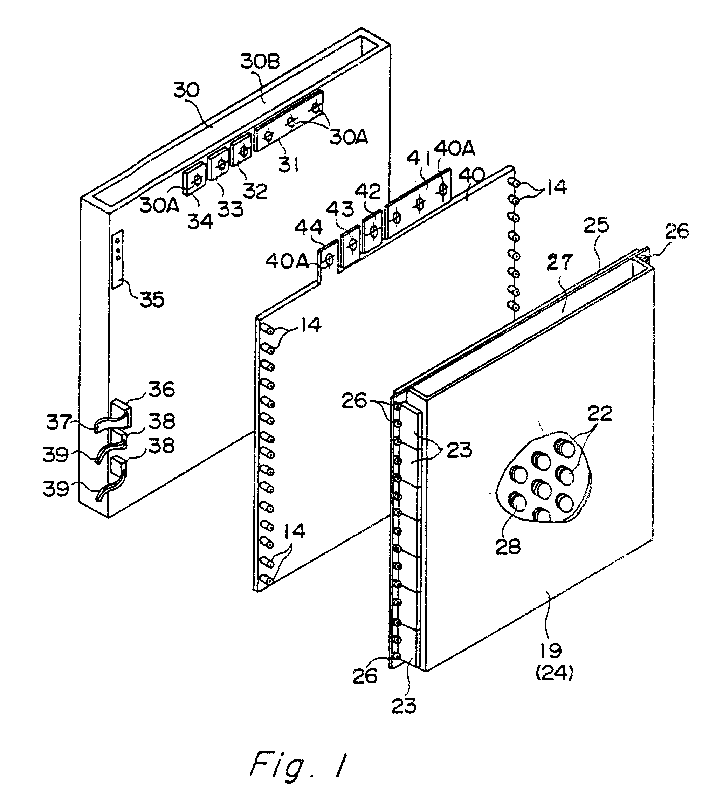

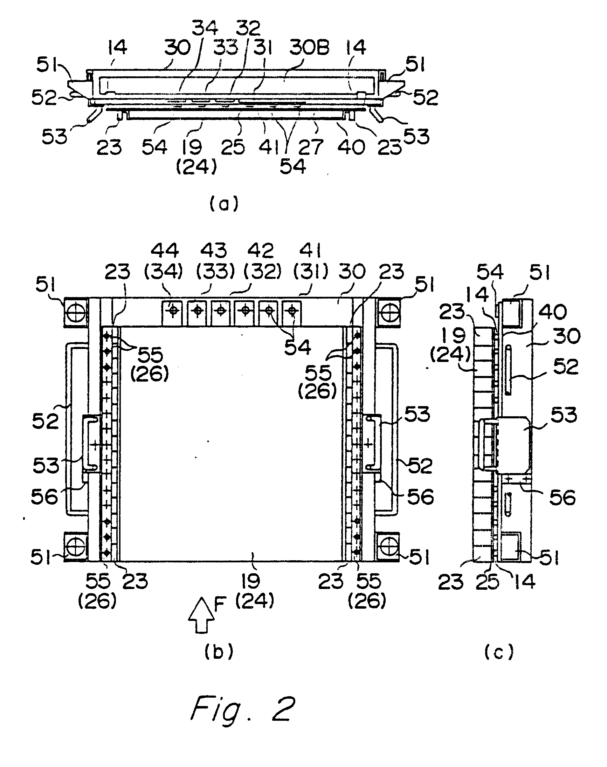

The present invention will be explained in detail with reference to an embodiment illustrated in Figs. 1 and 2. Fig. 1 is a perspective view of a disassembled structure. In Fig. 2, (a) is a plan view, (b) is a front elevation and (c) is a side elevation. Like elements are given like symbols throughout the drawings.

As shown in Fig. 1, power supply part 30 is formed almost to the same size as the one-board substrate. A side wall thereof is provided with output terminals 31, 32, 33, 34 having stepped portions, and the power source of power supply 30 is supplied to the one-board substrate 19 through posts 14 welded to bus plate 40 when the output terminals 31, 32, 33, 34 are connected to connecting pieces 41, 42, 43, 44 of the bus plate 40.

The bus plate 40 allows lamination of a plurality of conductive layers, through insulation layers, and the connecting pieces 41, 42, 43, 44 are respectively formed as extrusions from the conductive layers and moreover respective conductive layers are provided with welded predetermined posts which are conductive.

Thus, the bus plate 40 is stacked on the side wall of power supply 30, screws are tightened into threaded holes 30A of output terminals 31, 32, 33, 34 through mounting holes 40A of the connecting pieces 41, 42, 43, 44. In addition, power source is supplied to the one-board substrate 19 by screwing a screw to said end portion after positioning an end portion of a post 14 to a land 26 of one-board substrate 19. Accordingly, different power sources can be supplied by outputting different voltages, for example "ground G", "+2V" from the output terminals 31, 32, 33 and 34.

Such power supply 30 is required to be capable of displaying, for example, a ready or alarm condition through a display part 35, and to provide for cooling of heat generating elements such as internal power transistors by providing an aperture 30B at upper and lower portions so that ventilation for air cooling can be effected.

Furthermore, signals and main power source are input or output from the power supply 30 through connectors 36, 38 and cables 37, 39.

The one-board substrate 19 is formed by providing a cover 24 to a multilayered printing wiring board 25 mounting electronic parts 22 such as semiconductor elements providing heat radiation fins 28 and allowing input and output of signals through connectors 23 provided at both ends of multilayered printing wiring board 25 (cables are not shown).

Fig. 2(a), (b) and (c) shows details of assembled body with said structure.

The corners of power supply 30 are provided with metal 51 fixed at the time of housing into the enclosure 1 and both side surfaces are provided with welded grips 52 for carrying and a guide 56 for connecting bus plate 40.

Both side surfaces of bus plate 40 are provided with grips 53 having a guide surface which slides with the guide 56 mentioned above. The bus plate 40 is stacked on the power supply 30 and these are connected and fixed by fixing the connecting pieces 41, 42, 43, 44 to the output terminals 31, 32, 33, 34 with screws 54. The one-board substrate 19 is integrated to the bus plate 40 by screwing through posts 14 and said integrated body is further preferably connected and fixed to the power supply 30 in order to integrate all three elements.

Very effective cooling can be performed by sending air in the direction of an arrow mark F in Fig. 2(b). Namely, the air is circulated in the same direction to the aperture 30B for the power supply 30 and the space 27 between the multilayered printed wiring board 25 and the cover 24 for the one-board substrate 19.

The connecting piece 41 of bus plate 40 is formed with large size as shown in Fig. 1 because it is set to ground potential but it is desirable that such connecting piece be split into a plurality of connecting pieces as shown in Fig. 2(b) in order to improve reliability of contact with the terminal 31 of power supply 30.

As described above, the power supply 30, bus plate 40 and one-board substrate 19 are stacked and integrated in almost the same shape and thereby power source is supplied with the shortest path and total structure can be designed to be compact.

The aperture 30B is also provided for the power supply 30 in the same shape as the ventilation path 27 of the one-board substrate and thereby the amount of air for both during cooling can be matched easily.

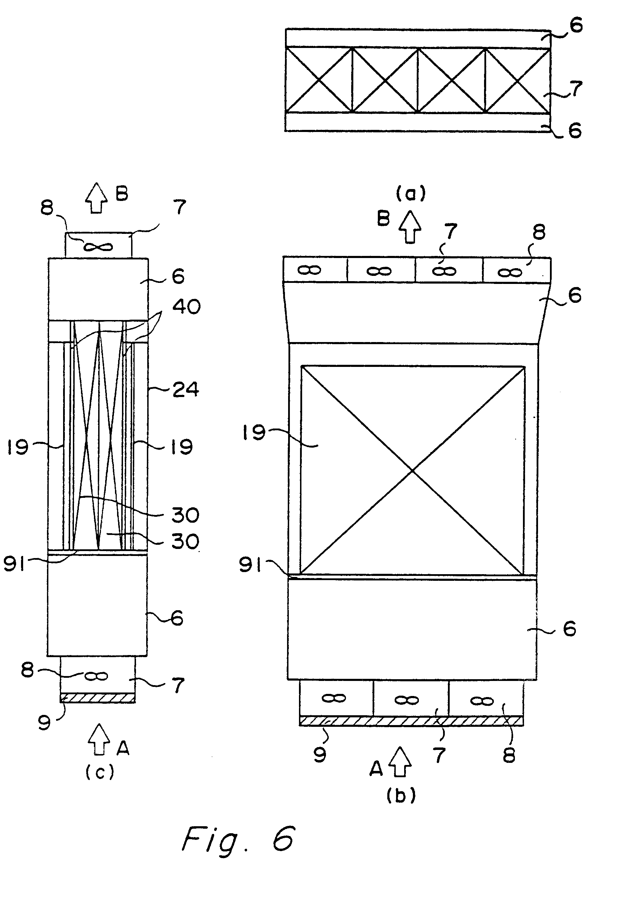

Fig. 6 shows a mounting structure and enclosure of electronic apparatus constituted as shown in Figs. 1 and 2. For improvement of mounting density, a pair of electronic apparatuses are arranged back to back and are fan cooled in common.

Fig. 6(a) is a plan view, (b) is a front elevation and (c) is a side elevation. The same elements as those shown in Fig. 3 are given the same symbols.

As shown in Fig. 6, power supplies 30 are arranged back to back, one-board substrates 19 are engaged to surfaces where bus plates 40 are welded, and moreover are covered with air covers 24 and ducts 6 and fan units 7 are provided at upper and lower portions.

When a fan 8 is driven, air is taken in the direction of arrow marks A in Figs. 6(b) and (c) through the filter 9, which filters the external air, and an adjusting plate 91 which adjusts the amount of air for ventilation, and such air is exhausted in the direction of arrow mark B, for air cooling. By air cooling the pair of electronic apparatuses arranged back to back with a common fan unit, not only can mounting efficiency be improved but also balance in amount of air to both electronic apparatuses can be stabilised and the cables can also be extended easily from the connector 23.

The present invention can be widely applied with large effect as the mounting structure for electronic apparatus such as an electronic computer and electronic switching equipment which is required to have a high mounting density and consumes a comparatively large amount of power.

## Claims

1. An electronic apparatus mounting structure comprising a bus plate (40) which is formed by stacking a plurality of conductive layers through insulating layers; the conductive layers corresponding to a plurality of power supply voltages; the bus plate being provided with a plurality of posts (14) electrically connected to both the conductive layers and a plurality of connecting pieces (41, 42, 43, 44) extrudingly formed at different positions from each conductive layer at the one surface thereof,

a power supply (30) which comprises the power supply circuit which supplies said plurality of power supply voltages and provides a plurality of output terminals (31, 32, 33, 34) formed at positions respectively corresponding to the positions of the plurality of connecting pieces of said bus plate,

a printed wiring board (25) having electronic parts (22) mounted thereon and having power supply lands (26) at positions corresponding to the positions of the plurality of posts of said bus plate,

the printed wiring board being stacked on one surface of the bus plate and being secured to the bus plate, the lands of said printed wiring board being electrically connected to the corresponding posts at the one surface of said bus plate, said power supply being located at the other surface of said bus plate and being secured to the bus plate, each connecting piece of the bus plate being electrically connected to each corresponding output terminal of the power supply.

2. An electronic apparatus mounting structure as claimed in claim 1 in which:-

said printed wiring board (25) is provided with a cover (24) which covers said mounted parts (22) and forms an air cooling duct (27),

said power supply (30) is provided with apertures (30B) at both end surfaces along a direction the same as that of air flowing in the path of said duct (27) formed by said cover (24), so that air cooling can be performed for the power supply (30) by air flowing in said direction, and

said printed wiring board (25) and said power supply (30) are cooled by a common air cooling fan (8).

3. An electronic apparatus mounting structure as claimed in claim 2 in which two assemblies, each of which is composed of a printed wiring board (25), bus plate (40) and power supply (30), are provided, the power supply sides of the two assemblies being arranged opposed to each other, and an air cooling fan (8) is provided to at least one end of an air flowing path such that the two assemblies are air-cooled by a common cooling fan (8).

**Revendications**

1. Structure de montage de dispositifs électroniques comportant une plaque (40) qui constitue un bus et qui est formée par empilage d'une pluralité de couches conductrices à travers des couches isolantes; des couches conductrices correspondant à une pluralité de tensions d'alimentation puissance; la plaque constituant le bus comprenant une pluralité de broches (14) électriquement connectées à la fois aux couches conductrices et à une pluralité de pièces de connexion (41, 42, 43, 44) formées sous forme de saillies, à partir de chaque couche conductrice en positions différentes et sur l'une de ses surfaces,

une alimentation puissance (30) qui comprend le circuit d'alimentation puissance qui amène ladite pluralité de tensions d'alimentation puissance et présente une pluralité de bornes de sortie (31, 32, 33, 34) formées en des positions correspondant respectivement aux positions de la pluralité de pièces de connexion de ladite plaque constituant le bus,

une carte de circuit imprimé (25) sur laquelle sont montées des pièces électroniques (22) et qui présente des bossages d'alimentation puissance (26) en des positions correspondant aux positions de la pluralité des broches de ladite plaque constituant le bus,

la carte de circuit imprimé étant empilée sur l'une des surfaces de la plaque constituant le bus et étant fixée à la plaque constituant le bus, les bossages de ladite carte de circuit imprimé étant électriquement connectés aux broches correspondantes qui se trouvent sur l'une des surfaces de ladite plaque constituant le bus, ladite alimentation puissance étant située sur l'autre surface de ladite plaque constituant le bus et étant fixée à la plaque constituant le bus, chaque pièce de connexion de la plaque constituant le bus étant électriquement connectée à chaque borne de sortie correspondante de l'alimentation puissance.

2. Structure de montage de dispositifs électroniques comme revendiqué dans la revendication 1, dans laquelle:

- ladite carte de circuit imprimé (25) comporte un couvercle (24) qui couvre lesdites pièces (22) qui y sont montées et forme une gaine (27) de refroidissement à l'air,

- ladite alimentation puissance (30) comporte des ouvertures (30B) aux deux surfaces d'extrémité, selon une direction qui est la même que celle de l'air qui s'écoule sur le chemin de ladite gaine (27) formée par ledit couvercle (24), de sorte que le refroidissement à l'air peut être effectué, pour l'alimentation puissance (30), par l'air qui s'écoule dans ladite direction et

- ladite carte de circuit imprimé (25) et ladite alimentation puissance (30) sont refroidies par un ventilateur commun (8) de refroidissement à l'air.

3. Structure de montage de dispositifs électroniques comme revendiqué dans la revendication 2, dans laquelle sont prévus deux ensembles dont chacun est composé d'une carte de circuit imprimé (25), d'une plaque constituant un bus (40) et d'une alimentation puissance (30), les faces d'alimentation puissance des deux ensembles étant disposées opposées l'une à l'autre, et dans laquelle un ventilateur (8) de refroidissement à l'air est prévu à au moins l'une des extrémités d'un chemin d'écoulement de l'air de façon que les deux ensembles soient refroidis à l'air par un ventilateur commun de refroidissement (8).

**Patentansprüche**

1. Aufbau zur Montage elektronischer Vorrichtungen, mit einer Bus-Platte (40), die durch Stapeln einer Vielzahl von leitenden Schichten über Isolationsschichten gebildet ist; wobei die leitenden Schichten einer Vielzahl von Energieversorgungsspannungen entsprechen; die Bus-Platte mit einer Vielzahl von Pfosten (14) versehen ist, die elektrisch sowohl mit den leitenden Schichten als auch einer Vielzahl von Verbindungsteilen (41, 42, 43, 44) verbunden sind, die durch Fließpressen an verschiedenen Positionen von jeder leitenden Schicht an ihrer einen Oberfläche gebildet sind,

einer Energieversorgung (30), die die Energieversorgungsschaltung umfaßt, welche die genannte Vielzahl von Energieversorgungsspannungen liefert und eine Vielzahl von Ausgangsanschlüssen (31, 32, 33, 34), die an Positionen gebildet sind, die jeweils den Positionen der Vielzahl von Verbindungsteilen der genannten Bus-Platte entsprechen, vorsieht,

eine gedruckte Schaltungskarte (25), auf der elektronische Teile (22) montiert sind und die Energiezuführ-Leiterzüge (26) an Positionen hat, die den Positionen der Vielzahl von Pfosten auf der genannten Bus-Platte entsprechen,

wobei die gedruckte Schaltungskarte auf einer Oberfläche der Bus-Platte gestapelt und an der Bus-Platte gesichert ist, die Leiterzüge der gedruckten Schaltungskarte elektrisch mit den entsprechenden Pfosten an der einen Oberfläche der genannten Bus-Platte verbunden sind, und die Energieversorgung an der anderen Oberfläche der genannten Bus-Platte angeordnet und an der Bus-Platte gesichert ist, wobei jedes Verbindungsstück der Bus-Platte elektrisch mit jedem entsprechenden Ausgangsanschluß der Energieversorgung verbunden ist.

2. Aufbau zur Montage elektronischer Vorrichtungen nach Anspruch 1, bei dem:-

die gedruckte Schaltungskarte (25) mit einer Abdeckung (24) versehen ist, welche die montierten Teile (22) abdeckt und einen Luftkühlungskanal (27) bildet,

die Energieversorgung (30) mit einer Öffnung (30B) an beiden Endoberflächen längs einer Richtung derselben wie jene des Luftstromes in dem Weg des genannten Kanals (27) vorgesehen ist, der durch die Abdeckung (24) gebildet wird, so daß Kühlluft für die Energieversorgung (30) durch einen Luftstrom in der genannten Richtung durchgeführt werden kann, und

die gedruckte Schaltungskarte (25) und die genannte Energieversorgung (30) werden durch einen gemeinsamen Luftkühlventilator (8) gekühlt.

3. Aufbau zur Montage elektronischer Vorrichtungen nach Anspruch 2, in welchem zwei Anordnungen, von denen jede aus einer gedruckten Schaltungskarte (25), einer Bus-Platte (40) und einer Energieversorgung (30) besteht, vorgesehen sind, wobei die Energiezuführseiten der beiden Anordnungen einander gegenüber angeordnet sind, und ein Luftkühlventilator (8) für wenigstens ein Ende des Luftstromweges vorgesehen ist, so daß die beiden Anordnungen durch einen gemeinsamen Kühlventilator (8) luftgekühlt werden.

Fig. 1

*Fig. 2*

Fig. 3

Fig. 4

Fig. 5

11

*Fig. 6*